(19) Europäisches Patentamt

European Patent Office

Office européen des brevets

(11) EP 1 124 331 A2

(12) **EUROPÄISCHE PATENTANMELDUNG**

(43) Veröffentlichungstag:
**16.08.2001 Patentblatt 2001/33**

(51) Int Cl.⁷: **H03K 19/08**, H01L 21/768

(21) Anmeldenummer: 01101724.1

(22) Anmeldetag: **25.01.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **09.02.2000 DE 10005620**

(71) Anmelder: **Infineon Technologies AG**
**80506 München (DE)**

(72) Erfinder: **Brox, Martin**
**80636 München (DE)**

(74) Vertreter: **MÜLLER & HOFFMANN Patentanwälte**
**Innere Wiener Strasse 17**
**81667 München (DE)**

(54) **Halbleiterschaltungsanordnung mit einer Leitungseinrichtung und einer Justiereinrichtung zum Beeinflussen der Signallaufzeiten**

(57) Zur flexibleren Abstimmung von Signallaufzeiten in einer Schaltungsanordnung aus einer Leitungseinrichtung und einer Mehrzahl darauf zugreifender elektronischer Bauelemente wird vorgeschlagen, im Bereich der Bauelemente zusätzliche Kapazitäten auszubilden, welche steuerbar variierbar sind.

Fig. 1

EP 1 124 331 A2

**Beschreibung**

Die Erfindung betrifft eine Schaltungsanordnung gemäß dem Oberbegriff des Anspruchs 1.

Bei vielen Schaltungsanordnungen, insbesondere in der Mikroelektronik und Halbleitertechnik, ist es notwendig, dass eine Mehrzahl elektronischer Bauelemente, welche über eine Leitungseinrichtung, wie z.B. einem Bussystem, mit einer Mehrzahl von Leitungen verbunden sind, bestimmte Signale empfängt, welche z.B. von einer sendenden Einrichtung stammen. Dabei ist es insbesondere, gerade in getakteten System, weiter erforderlich, dass die Ankunft oder der Empfang der Signale bei den elektronischen Bauelementen von einer vorgeschriebenen zeitlichen Abfolge möglichst geringfügig abweichen, damit eine vorgegebene zeitliche Struktur weiterer Verarbeitungsschritte innerhalb der Schaltungsanordnung in definierter Art und Weise eingehalten werden kann.

Insbesondere bei Speichersystemen wird ein Aufbau bevorzugt, bei welchem die elektronischen Bauelemente oder Speicherkomponenten entlang einer übertragenden Leitungseinrichtung, nämlich einem Bussystem, angeordnet sind. Damit die Signale, welche über die Übertragungsleitungseinrichtung übermittelt werden sollen, in einer wohldefinierten zeitlichen Abfolge oder Synchronisierung verbleiben, während sie entlang der Übertragungsleitungseinrichtung übertragen werden, müssen die Signallaufzeiten oder die Signalverzögerungen abgestimmt und mit einer bestimmten Genauigkeit eingestellt werden.

Dies kann zum einen dadurch erreicht werden, dass die Übertragungsleitungseinrichtungen selbst entsprechend konzipiert und aufgebaut werden, insbesondere hinsichtlich ihrer kapazitiven und induktiven Eigenschaften.

Zum anderen besitzen auch die an die Leitungseinrichtung angeschlossenen elektronischen Bauelemente, also insbesondere die Speicherkomponenten, elektrische Eigenschaften, z.B. eine Kapazität und eine Induktivität, welche die Signallaufzeiten für jede einzelne Leitungskomponente der Leitungseinrichtung beeinflussen können.

Um also eine vordefinierte Synchronizität der auf den verschiedenen Leitungskomponenten der Leitungseinrichtung laufenden Signale hinsichtlich der verschiedenen an die Leitungseinrichtung angeschlossenen elektronischen Bauelemente zu gewährleisten, wurde im Stand der Technik vorgeschlagen, zusätzliche optionale Justiereinrichtung mit Trimmkapazitäten oder -kondensatoren auszubilden, welche im Bereich der elektronischen Bauelemente selbst und/oder aber im Bereich von Verbindungseinrichtungen der elektronischen Bauelemente mit der Leitungseinrichtung so ausgebildet sind, dass aufgrund der zusätzlichen Gesamtkapazitäten der Justiereinrichtungen die Signallaufzeiten des Signals auf den Leitungen beeinflussbar sind.

Bei den bekannten Schaltungsanordnungen wie Halbleitermodulen, Chips, Speicherbausteinen und dergleichen ist dabei problematisch, dass die vorzusehenden optionalen zusätzlichen Kapazitäten der Justiereinrichtungen und ihre leitenden Verbindungen bei der Produktion eines z.B. üblicherweise schichtförmig aufgebauten elektronischen Bauteils oder einer Schaltungsanordnung sehr frühzeitig im Produktionsprozess angelegt und ausgebildet werden müssen und sich dann nicht mehr variieren lassen.

Selbst wenn aufgrund theoretischer Berechnungen oder aufgrund von Messungen an Prototypen oder früheren Produktionslinien die vorzusehenden optionalen Kapazitäten derart ausgewählt wurden, dass sie bestimmten Laufzeitanforderungen der Signale oder Signalkomponenten auf den Leitungseinrichtungen entsprechen, so sind die einmal ausgebildeten und konzipierten zusätzlichen Gesamtkapazitäten der Justiereinrichtungen für einen einzigen bestimmten Typus elektronischer Bauelemente oder Schaltungsanordnungen festgelegt. Dies führt dazu, dass veränderten Laufzeitanforderungen an die Signale, welche sich aufgrund von Veränderungen oder Schwankungen des Produktionsprozesses, aufgrund von Alterungserscheinungen, aufgrund von Wechselwirkungen der elektronischen Bauelemente oder der Schaltungsanordnungen mit anderen vorgesehenen elektronischen Bauelementen oder Schaltungsanordnungen entstehen können, nicht ohne erheblichen Aufwand im Produktionsprozess Rechnung getragen werden kann. Auch auf sich spontan ergebende Kundenanforderungen hinsichtlich der Signallaufzeiten kann nicht flexibel genug reagiert werden, weil dazu die auf den elektronischen Bauteilen oder der Schaltungsanordnung vorgesehenen zusätzlichen Kapazitäten der Justiereinrichtungen grundsätzlich neu konzipiert werden müssten. Dies würde eine Umstellung des Produktionsprozesses und somit eine Bauteilvariation erfordern.

Sämtliche Maßnahmen aber hätten aufgrund zeitlicher Aspekte, des Materialeinsatzes und einer u.U. erhöhten Produktion außerhalb der gewünschten Spezifikation beim Stand der Technik auch zusätzliche Kosten zur Folge.

Der Erfindung liegt die **Aufgabe** zugrunde, eine Schaltungsanordnung zu schaffen, bei welcher Signallaufzeiten auf den Leitungen auf besonders zuverlässige und gleichwohl flexible Art und Weise beeinflussbar sind.

Die Aufgabe wird erfindungsgemäß durch eine gattungsgemäße Schaltungsanordnung mit den kennzeichnenden Merkmalen des Anspruchs 1 gelöst. Vorteilhafte Weiterbildungen der erfindungsgemäßen Schaltungsanordnung sind Gegenstand der abhängigen Unteransprüche.

Bei der gattungsgemäßen Schaltungsanordnung ist mindestens eine Leitungseinrichtung vorgesehen, welche eine Mehrzahl von Leitungen oder Einzelleitungen zur Übertragung eines Signals aufweist. Des weiteren weist die gattungsgemäße Schaltungsanordnung eine Mehrzahl elektronischer Bauelemente auf, welche jeweils über vorgesehene Verbindungseinrichtungen mit der Leitungseinrichtung verbindbar und zur Aufnahme des Signals ausgebildet sind. Ferner ist eine Mehrzahl Justiereinrichtungen vorgesehen, welche im Bereich der elektronischen Bauelemente und/oder der Verbindungseinrichtungen in Kontakt mit den Verbindungseinrichtungen so ausgebildet sind, dass aufgrund zusätzlicher Gesamtkapazitäten der Justiereinrichtungen die Signallaufzeiten auf den Leitungen beeinflussbar sind.

Die erfindungsgemäße Lösung der Aufgabe besteht nun gerade darin, dass die Justiereinrichtungen so ausgebildet sind, dass die Werte der zusätzlichen Gesamtkapazitäten der Justiereinrichtungen jeweils steuerbar variierbar sind.

Im Gegensatz zum Stand der Technik, bei welchem auf den elektronischen Bauelementen oder auf der Schaltungsanordnung mit den elektronischen Bauelementen die Kapazitäten der Justiereinrichtungen bei Produktion der Schaltungsanordnung festgelegt und fixiert sind, sieht die erfindungsgemäße Lösung ihrer Grundidee nach eine steuerbare Veränderbarkeit der zusätzlichen Gesamtkapazitäten der Justiereinrichtungen vor, wodurch erreicht wird, dass auch die Einflussnahme der Gesamtkapazitäten auf die Signallaufzeiten des Signals auf den einzelnen Leitungen oder Leitungseinrichtungen in variabler, also flexibler Art und Weise erfolgen kann. Dadurch ist es im Gegensatz zum Stand der Technik mit der erfindungsgemäßen Schaltungsanordnung möglich, sich ändernden Signallaufzeitanforderungen gerecht zu werden und diesen zu entsprechen.

Besonders flexibel gestaltet sich die Einflussnahme auf die Signallaufzeiten, wenn gemäß einer bevorzugten Ausführungsform der erfindungsgemäßen Schaltungsanordnung die Justiereinrichtungen jeweils eine Mehrzahl von Einzelkapazitäten oder eine einzige, aber steuerbar variierbare Einzelkapazität aufweisen, wobei dann die Einzelkapazität bzw. die Einzelkapazitäten zusammenwirkend jeweils im wesentlichen die zusätzliche Gesamtkapazität der jeweiligen Justiereinrichtung bilden.

Beim Vorsehen einer Mehrzahl von Einzelkapazitäten ergibt sich z.B. aus der Möglichkeit, diese Einzelkapazitäten auf verschiedene Arten und Weisen zu verschalten, eine hohe Flexibilität, z.B. beim Parallelschalten, wobei sich die Einzelkapazitäten der jeweiligen Justiereinrichtung gerade zur Gesamtkapazität dieser Justiereinrichtung addieren. Beim Vorsehen einer einzigen steuerbar variierbaren Einzelkapazität folgt die Flexibilität aus der steuerbaren Variation der Einzelkapazität als solcher.

Bei dieser Vorgehensweise werden die Einzelkapazitäten einer gegebenen Justiereinrichtung z.B. zueinander und/oder zu einer jeweiligen Verbindungseinrichtung parallel und mit einem festen Potential, insbesondere mit Masse, verbunden schaltbar ausgebildet.

Dadurch ergeben sich besonders stabil definierte Verhältnisse, weil aufgrund der bekannten Kirchhoffschen Gesetze die Parallelschaltung von Einzelkapazitäten eine besonders einfache und übersichtliche Kombination der Einzelkapazitäten zur Gesamtkapazität zulässt, wobei ein fester Bezugspunkt hinsichtlich des elektrischen Potentials, insbesondere gegenüber Masse, grundsätzlich zu bevorzugen ist.

Beim Parallelschalten von Kapazitäten addieren nämlich die Einzelkapazitäten der gegebenen Justiereinrichtung in der Summe zur Gesamtkapazität der Justiereinrichtung. Durch die jeweilige Schaltbarkeit der Einzelkapazitäten kann also auf eine bestimmte Anzahl von Kombinationen der Einzelkapazitäten zurückgegriffen werden, je nachdem, welche der Einzelkapazitäten genau in einem geschalteten oder nicht geschalteten Status gegenüber der jeweiligen Verbindungseinrichtung gesetzt und damit wirksam bzw. unwirksam ist.

Dabei ist es von besonderem Vorteil, dass die Einzelkapazitäten einer gegebenen Justiereinrichtung jeweils unabhängig voneinander wählbar ein- und/oder ausschaltbar ausgebildet sind.

Zur Realisierung des wählbaren Ein- und/oder Ausschaltens der jeweiligen Einzelkapazität einer gegebenen Justiereinrichtung ist in einer bevorzugten Ausführungsform der erfindungsgemäßen Schaltungsanordnung jeweils eine Schaltsteuereinrichtung ausgebildet. Durch diese Schaltsteuereinrichtung wird jeweils das steuerbare Ein- und/oder Ausschalten der Einzelkapazitäten und somit auch eine beliebige Kombination dieser Einzelkapazitäten zur Überlagerung zur Gesamtkapazität der jeweiligen Justiereinrichtung möglich.

Zum Setzen des Schaltstatus durch die Schaltsteuereinrichtung kann die Schaltsteuereinrichtung vorteilhafterweise zum Empfangen eines entsprechenden Steuersignals ausgebildet sein. Auch kann für mehrere oder alle Einzelkapazitäten einer oder mehrerer Justiereinrichtungen eine gemeinsame Schaltsteuereinrichtung vorgesehen sein, wobei dann auch ein komplexeres, z.B. entsprechend kodiertes, Steuersignal Verwendung finden kann.

Von besonderem Vorteil ist es aber, wenn die Schaltsteuereinrichtung jeweils direkt auf die anzusteuernde oder zu schaltende Einzelkapazität einer gegebenen Justiereinrichtung zugreift. Dazu ist es gemäß einer weiteren Ausgestaltungsform der erfindungsgemäßen Schaltungsanordnung vorgesehen, dass die Schaltsteuereinrichtung jeweils in einer Leitung zu einer jeweiligen Verbindungseinrichtung hin mit der jeweiligen Einzelkapazität einer gegebenen Justiereinrichtung in Serie schaltbar ausgebildet ist.

Zum Ein- und/oder Ausschalten der jeweiligen Einzelkapazität kann grundsätzlich als Schaltsteuereinrichtung jegliche Einrichtung verwendet werden, mit welcher die jeweilige Einzelkapazität zu einer jeweiligen Verbindungseinrichtung in einen kontaktierten/geschalteten oder in einer nicht kontaktierten/nicht geschalteten Zustand geschaltet werden kann.

Es ist auch vorgesehen, dass die Schaltsteuereinrichtung jeweils als Sicherungseinrichtung ausgebildet ist, insbesondere als sogenannte Laserfuse oder electrical fuse. Dabei wird durch ein Lichtsignal bzw. ein elektrisches Signal von extern der Kontaktstatus der jeweiligen Einzelkapazität einer gegebenen Justiereinrichtüng zu einer Verbindungseinrichtung hin von einem kontaktierten zu einem unterbrochenen Status hin geändert oder umgekehrt.

Diese genannten Sicherungseinrichtungen können auch in einem Zwischenschritt der Produktion der elektronischen Bauelemente oder der Schaltungsanordnung angesprochen werden, um bereits in einer Zwischenstufe der Schaltungsanordnung die entsprechenden Einzelkapazitäten der Justiereinrichtungen für eine entsprechende Beeinflussung der Signallaufzeiten anzupassen.

Besonders flexibel gestaltet sich das Anpassen der Signallaufzeiten dann, wenn gemäß einer weiteren bevorzugten Ausführungsform der erfindungsgemäßen Schaltungsanordnung für jede Einzelkapazität ein Speicherelement, insbesondere ein 1-Bit-Speicherelement, vorgesehen ist und wenn durch die Schaltsteuereinrichtung aufgrund des Inhalts des jeweiligen Speicherelements ein Schaltsignal zum Setzen eines Schaltzustandes und/oder der Größe der jeweiligen Einzelkapazität generierbar ist. Dadurch wird erreicht, dass auch ohne zusätzliche Maßnahmen, z.B. eines Lasers zum Aktivieren oder Deaktivieren einer Laserfuse, der Schaltzustand bzw. die Größe der jeweiligen Einzelkapazität geändert werden kann, und zwar in reproduzierbarer Art und Weise aufgrund des Speicherinhalts.

Die Speicherelemente können als Teil der Schaltsteuereinrichtungen oder separat davon ausgebildet sein, wobei im letzteren Fall die Speicherinhalte eben auch als Steuersignale für die Schaltsteuereinrichtungen aufgefasst werden können. Auch kann für mehrere oder alle Einzelkapazitäten einer, mehrerer oder aller Justiereinrichtungen eine gemeinsame Speichereinrichtung vorgesehen sein, durch deren Speicherinhalte gerade die Konfiguration der geschalteten und der nicht geschalteten Einzelkapazitäten und/oder deren Wert repräsentierbar ist.

Dabei ist es von besonderem Vorteil, wenn eine Zugriffseinrichtung vorgesehen ist, durch welche der Schaltzustand und/oder die Größe der jeweiligen Einzelkapazität, insbesondere extern, direkt und/oder indirekt über eine Beeinflussung von Speicherinhalten im wesentlichen frei einstellbar ist.

Es kann somit mittels der jeweiligen Speicherelemente mit oder ohne die Zugriffseinrichtung und gegebenenfalls über eine externe Programmierung festgelegt werden, welche der jeweiligen Einzelkapazitäten geschaltet sind und welche nicht, um eine notwendige Kombination der jeweiligen Einzelkapazitäten zu den Gesamtkapazitäten zu erreichen.

Über den externen Zugriff können dann gegebenenfalls die Speicherinhalte der jeweiligen Speicherelemente so geändert werden, dass entsprechende Steuersignale zum Setzen eines anderen, nämlich angepassten oder verbesserten, Schaltzustandes generiert werden, um besser abgestimmte Gesamtkapazitäten und damit verbesserte oder gewünschte Signallaufzeiten auf der Leitungseinrichtung der Schaltungsanordnung zu erzeugen.

Auf diese Weise wird erreicht, dass die Gesamtkapazitäten der einzelnen Justiereinrichtungen, insbesondere extern, frei programmierbar sind. Folglich ist es nicht nur möglich, die Laufzeitverhältnisse auf der Leitungseinrichtung der Schaltungsanordnung zu verbessern, sondern auch bewusst Tests mit besonders stark abweichenden Laufzeiten durchzuführen, um die Stabilität der Schaltungsanordnung und ihres Verhaltens und/oder das Zusammenwirken einer derartigen Schaltungsanordnung im Rahmen einer übergeordneten Vorrichtung zu studieren.

Um eine möglichst flexible Variation der Gesamtkapazitäten der Justiereinrichtungen zu ermöglichen, ist es gemäß einer weiteren vorteilhaften Weiterbildung der erfindungsgemäßen Schaltungsanordnung vorgesehen, dass die Werte der Einzelkapazitäten der Justiereinrichtungen jeweils der Beziehung

$$C_j = C_0 \cdot 2^{j-1}$$

genügen, wobei j von 1 bis zur jeweiligen Anzahl N der Einzelkapazitäten, insbesondere bis 4, läuft und wobei $C_0$ eine kleinste Grundkapazität, insbesondere etwa 10 fF, bedeutet. Dies entspricht einer binären Kodierung der Werte der Einzelkapazitäten, wobei aber auch jede andere Form von Kodierung oder Zuordnung der Werte der Einzelkapazitäten gewählt werden kann.

Bei gleichzeitiger Parallelschaltung dieser binär kodierten Einzelkapazitäten $C_j$ ergibt sich somit, dass die Gesamtkapazität als Summe der Einzelkapazitäten von 0 bis $C_0 (2^N - 1)$ läuft. Bei vier Einzelkapazitäten, also N = 4, und einer Grundkapazität $C_0$ = 10 fF wäre somit ein Überstreichen des Bereichs von 0 bis 150 fF mit einer Auflösung von 10 fF erreicht. $C_0$ gibt somit die Genauigkeit an, mit welcher eine Gesamtkapazität abgestimmt werden kann.

Üblicherweise ist es bei Speicherbausteinen und anderen Schaltungsanordnungen der Mikroelektronik und Halbleitertechnik notwendig, Kapazitäten elektronischer Bauelemente oder Schaltungsanordnungen in einer Größenordnung von 200 fF mit einer Genauigkeit besser als 50 fF zu korrigieren. Die oben diskutierte binäre Kodierung erfüllt diese Anforderungen.

Die tatsächlichen Ausgestaltungsformen der Einzelkapazitäten der Justiereinrichtungen können sämtlichen elektronischen Komponenten und Strukturen, insbesondere der Mikroelektronik und Halbleitertechnik, entlehnt sein, die vorzugsweise auf einfache Art und Weise eine Kapazität realisieren. Es ist möglich, dass die Einzelkapazitäten der Justiereinrichtungen jeweils als Sperrschicht- oder Diffusionsschichtkapazität einer Diode, eines n-Kanal-Feldeffekttransistors, eines allgemeinen np-Übergangs oder dergleichen ableitbar sind. Ferner kann die Einzelkapazität jeweils als Kapazität eines Metallschichtkondensators oder dergleichen ableitbar sein.

Zusammenfassend besteht eine Kernidee der oben beschriebenen Erfindung also darin, auf Schaltungsanordnungen Justiereinrichtungen mit steuerbar variierbaren Einzelkapazitäten vorzusehen, durch welche die Eingangskapazitäten elektronischer Bauelemente oder Teile der Schaltungsanordnung, insbesondere gegebenenfalls nach einer Waferherstellung, derart verändert werden können, dass Signallaufzeiten in der Schaltungsanordnung auf besonders einfache und flexible Art und Weise beeinflussbar sind.

Anwendung kann das erfindungsgemäße Konzept einer Schaltungsanordnung mit steuerbar variierbaren Einzelkapazitäten insbesondere bei RDRAM- oder SDRAM-Bausteinen oder dergleichen finden.

Nachfolgend wird die Erfindung anhand einer schematischen Zeichnung auf der Grundlage bevorzugter Ausführungsbeispiele der erfindungsgemäßen Schaltungsanordnung weiter erläutert. In dieser zeigt

Fig. 1      ein schematisches Blockdiagramm einer ersten Ausführungsform der erfindungsgemäßen Schaltungsanordnung,

Fig. 2      Details einer zweiten Ausführungsform der erfindungsgemäßen Schaltungsanordnung in Form eines schematischen Blockdiagramms,

Fig. 3      ein schematisches Blockdiagramm eines dritten Ausführungsbeispiels der erfindungsgemäßen Schaltungsanordnung, und

Fig. 4A-C      schematisch Ausführungsformen für Einzelkapazitäten zur Anwendung in einem Ausführungsbeispiel der erfindungsgemäßen Schaltungsanordnung.

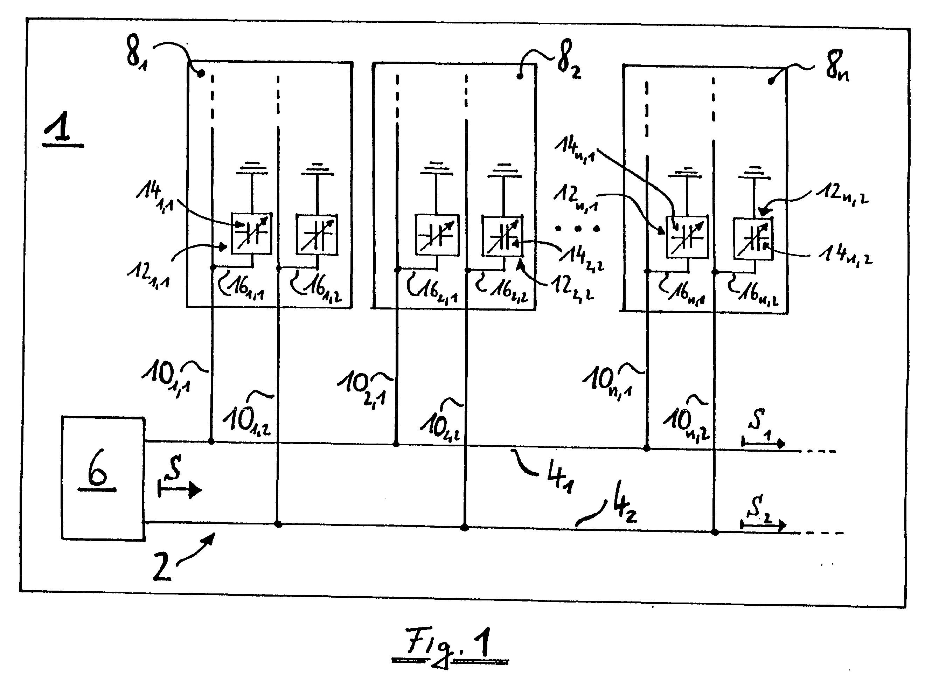

Das schematische Blockdiagramm der Fig. 1 zeigt eine erste Ausführungsform der erfindungsgemäßen Schaltungsanordnung 1.

In dieser Schaltungsanordnung 1 ist eine Mehrzahl elektronischer Bauelemente $8_1$, ...., $8_n$ über Verbindungseinrichtungen $10_{1,1}$, ..., $10_{n,1}$ mit einer Buseinrichtung oder Leitungseinrichtung 2 verbunden, welche eine Mehrzahl Leitungen $4_1$ und $4_2$ aufweist. Die Multiplizität der Leitungen kann je nach Breite des Busses höher sein und ist nicht auf zwei Leitungen $4_1$ und $4_2$ beschränkt. Die Einzelleitungen $4_1$ und $4_2$ werden in dem in Fig. 1 gezeigten Ausführungsbeispiel von extern mit einem Signal S mit Signalkomponenten $S_1$ und $S_2$ beaufschlagt.

Durch Wechselwirkung der Einzelleitungen oder Leitungen $4_1$ und $4_2$ mit den Leitungseinrichtungen $10_{1,1}$, ...., $10_{n,1}$ und insbesondere mit den jeweiligen Gesamtkapazitäten der elektronischen Bauteile $8_1$, ...., $8_n$ weisen die Laufzeiten $t_1$ und $t_2$ der Signalkomponenten $S_1$ und $S_2$ unter Umständen Abweichungen auf, die außerhalb der Spezifikation der Schaltungsanordnung und insbesondere des Busses oder der Leitungseinrichtung stehen.

Diese Abweichungen können altersbedingt sein oder auch auf Variationen innerhalb des Produktionsprozesses beruhen.

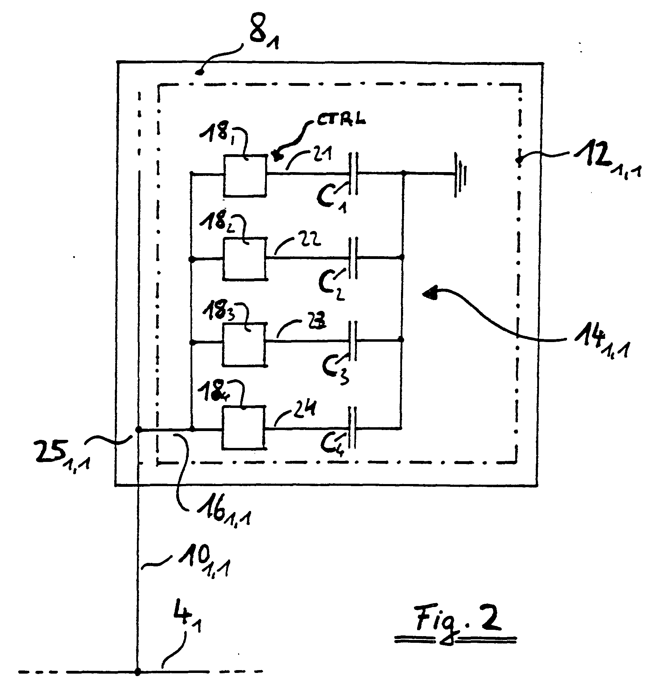

Zur Beeinflussung und Anpassung der Signallaufzeiten $t_1$ und $t_2$ sind in dem in Fig. 1 gezeigten Ausführungsbeispiel der erfindungsgemäßen Schaltungsanordnung 1 innerhalb der elektronischen Bauteile $8_1$, ...., $8_n$ Justiereinrichtungen $12_{1,1}$, ...., $12_{n,2}$ über entsprechende Leitungseinrichtungen $16_{1,1}$, ...., $16_{n,2}$ mit den Verbindungseinrichtungen $10_{1,1}$, ...., $10_{n,1}$ verbunden. Diese Justiereinrichtungen $16_{1,1}$, ...., $16_{n,2}$ weisen erfindungsgemäß steuerbar variierbare Gesamtkapazitäten $14_{1,1}$, ...., $14_{n,2}$ auf und sind mit Masse verbunden. Fig. 2 zeigt mittels eines schematischen Blockdiagramms im Detail, wie ein elektronisches Bauelement $8_1$ hinsichtlich der Justiereinrichtung $12_{1,1}$ aufgebaut und mittels einer Verbindungseinrichtung $10_{1,1}$ mit einer Leitung $4_1$ einer Leitungseinrichtung 2 innerhalb eines Ausführungsbeispiels der erfindungsgemäßen Schaltungsanordnung verbunden ist. Es können entsprechende weitere Verbindungseinrichtungen je nach Anzahl der notwendigen äußeren Anschlüsse des elektronischen Bauelements $8_1$ vorgesehen sein.

An einen Knoten $25_{1,1}$, der z.B. als ein PAD eines integrierten Schaltkreises, eines Halbleitermoduls oder dergleichen ausgebildet sein kann, ist über eine Leitungseinrichtung $16_{1,1}$ die Justiereinrichtung $12_{1,1}$ kontaktiert. Diese weist eine Parallelschaltung von vier Einzelkapazitäten $C_1$, ...., $C_4$ gegen Masse auf. In einer jeweiligen Leitung 21 bis 24 sind zu den Einzelkapazitäten $C_1$, ...., $C_4$ entsprechende Schaltsteuereinrichtungen $18_1$, ...., $18_4$ in Serie geschaltet, um auf entsprechende Steuersignale CTRL hin die jeweilige Einzelkapazität $C_1$, ...., $C_4$ als geschaltet oder als nicht geschaltet zu setzen. Aus der Parallelschaltung der geschalteten Einzelkapazitäten ergibt sich in Addition als Summe die Gesamtkapazität $14_{1,1}$ der Justiereinrichtung $12_{1,1}$.

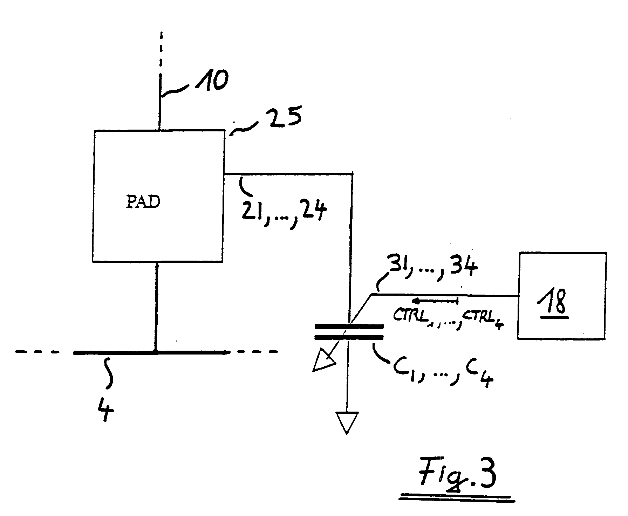

In dem schematischen Blockdiagramm der Fig. 3 ist eine weitere Ausführungsform der erfindungsgemäßen Schaltungsanordnung 1 gezeigt, wobei an einem Knoten 25 oder PAD eine Mehrzahl Leitungen 21 bis 24 kontaktiert ist, um jeweils Einzelkapazitäten $C_1$, ...., $C_4$ in Parallelschaltung zu einer Verbindungseinrichtung 10 zur Busleitung 4 über eine gemeinsame Schaltsteuereinrichtung 18 und Steuersignale $CTRL_1$, ..., $CTRL_4$ gegen Masse zu schalten. Die Kapazitäten $C_1$, ...., $C_4$ können sowohl hinsichtlich ihres absoluten Schaltzustandes - kontaktiert oder nicht kontaktiert - als auch hinsichtlich des Wertes ihrer Kapazität

über die Steuersignale CTRL$_1$, ..., CTRL$_4$ steuerbar sein. Die Steuersignale CTRL$_1$, ..., CTRL$_4$ werden über Steuerleitungen 31, ..., 34 zugeführt.

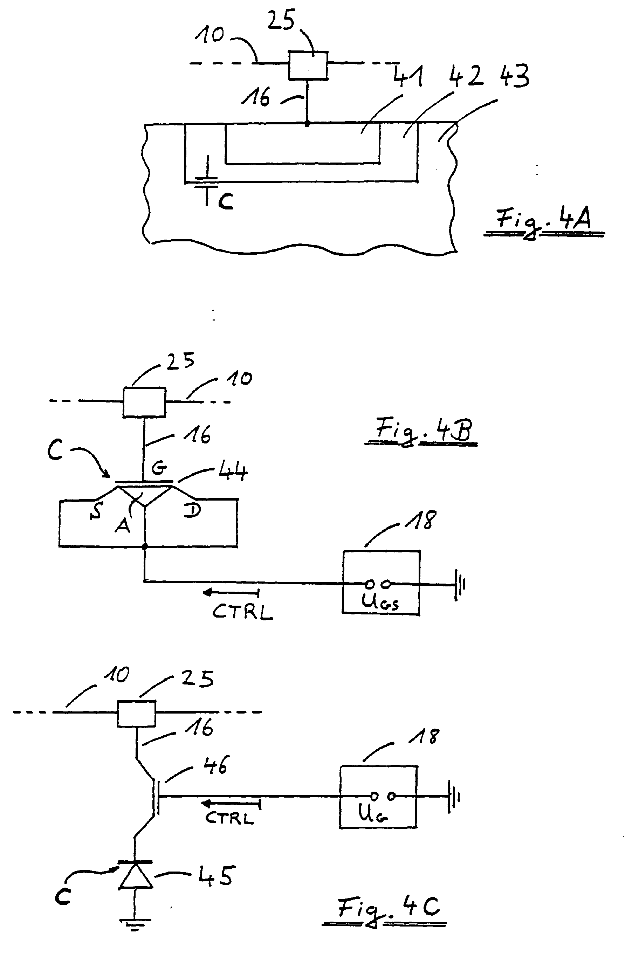

In den schematischen Darstellungen der Fig. 4A bis 4C sind verschiedene Ausführungsformen hinsichtlich ihres Wertes steuerbarer Kapazitäten dargestellt.

Bei der Ausführungsform der Fig. 4A wird eine Diffusionsschicht- oder Sperrschichtkapazität C einer n-Diffusionsschicht 41 in einer n-Wanne 42 gegenüber einem p-Substrat 43 realisiert, wobei die n-Diffusionsschicht im Halbleitersubstrat mittels einer Leitungseinrichtung 16 über einen Knoten 25 oder PAD 25 eines Halbleitermoduls verbunden ist.

Die Darstellung der Fig. 4B zeigt, wie die Gate-Kapazität eines n-Kanal-Feldeffekttransistors 44 (nFET) als Einzelkapazität C genutzt werden kann, wobei der Wert dieser Kapazität über die Spannung U$_{GS}$ zwischen Substrat S und Gate G - die auch auf Masse bezogen sein kann - als Steuersignal CTRL steuerbar ist und wobei Source S, Drain D und Substrat A des nFET 44 auf demselben Potential liegen. Die Steuerspannung U$_{GS}$ wird von der Steuerschalteinrichtung 18 generiert.

In Fig. 4C ist gezeigt, wie eine Diode 45 verwendet werden kann, um deren Diffusionsschicht- oder Sperrschichtkapazität als Einzelkapazität C auszunutzen. Durch einen zwischengeschalteten Feldeffekttransistor 46 wird diese Einzelkapazität C der Diode 45 mittels der über die Schaltsteuereinrichtung 18 aufgeprägten Gate-Spannung UG als Steuersignal CTRL zum PAD 25 und zur Verbindungseinrichtung 10 hin schaltbar.

## Patentansprüche

**1.** Halbleiterschaltungsanordnung, insbesondere Halbleitermodul, Chip oder dergleichen, mit:

- mindestens einer Leitungseinrichtung (2), welche eine Mehrzahl Leitungen ($4_1$, $4_2$) zur Übertragung eines Signals (S) aufweist,
- einer Mehrzahl elektronischer Bauelemente ($8_1$, ..., $8_n$), welche jeweils über vorgesehene Verbindungseinrichtungen ($10_{1,1}$, ..., $10_{n,2}$) mit der Leitungseinrichtung (2) verbindbar und zur Aufnahme des Signals (S) ausgebildet sind, und
- einer Mehrzahl Justiereinrichtungen ($12_{1,1}$, ..., $12_{n,2}$), welche im Bereich der elektronischen Bauelemente ($8_1$, ..., $8_n$) und/oder der Verbindungseinrichtungen ($10_{1,1}$, ..., $10_{n,2}$) in Kontakt mit den Verbindungseinrichtungen ($10_{1,1}$, ..., $10_{n,2}$) so ausgebildet sind, dass aufgrund zusätzlicher und in ihrem Wert steuerbar variierbarer Gesamtkapazitäten ($14_{1,1}$, ..., $14_{n,2}$) der Justiereinrichtungen ($12_{1,1}$, ..., $12_{n,2}$) die Signallaufzeiten ($t_1$, $t_2$) des Signals (S) auf den Leitungen ($4_1$, $4_2$) beeinflussbar sind,

- wobei die zusätzlichen Gesamtkapazitäten Gesamtkapazitäten ($14_{1,1}$, ..., $14_{n,2}$) der Justiereinrichtungen ($12_{1,1}$, ..., $12_{n,2}$) jeweils durch eine Mehrzahl Einzelkapazitäten (C$_1$, ..., C$_4$) oder durch eine einzige steuerbar variierbare Einzelkapazität (C) gebildet werden,
- wobei zum wählbaren Ein- und/oder Ausschalten der jeweiligen Einzelkapazitäten (C, C$_1$, ..., C$_4$) jeweils eine Schaltsteuereinrichtung (18, $18_{1,1}$, ..., $18_{n,2}$) ausgebildet ist und
- wobei die Schaltsteuereinrichtung (18, $18_{1,1}$, ..., $18_{n,2}$) jeweils als Sicherungseinrichtung, insbesondere als Laserfuse oder electrical fuse, ausgebildet ist.

**2.** Schaltungsanordnung nach Anspruch 1, **dadurch gekennzeichnet,** dass die Einzelkapazitäten (C, C$_1$, ..., C$_4$) einer gegebenen Justiereinrichtung ($12_{1,1}$, ..., $12_{n,2}$) zu einander und/oder zu einer jeweiligen Verbindungseinrichtung ($10_{1,1}$, ..., $10_{n,2}$) parallel mit einem festen Potential, insbesondere mit Masse, verbunden schaltbar ausgebildet sind.

**3.** Schaltungsanordnung nach einem der vorangehenden Ansprüche, **dadurch gekennzeichnet,** dass die Einzelkapazitäten (C, C$_1$, ..., C$_4$) einer gegebenen Justiereinrichtung ($12_{1,1}$, ..., $12_{n,2}$) jeweils unabhängig von einander wählbar ein- und/oder ausschaltbar ausgebildet sind.

**4.** Schaltungsanordnung nach einem der vorangehenden Ansprüche, **dadurch gekennzeichnet,** dass die Schaltsteuereinrichtung (18, $18_{1,1}$, ..., $18_{n,2}$) jeweils in einer Leitung zu einer jeweiligen Verbindungseinrichtung ($10_{1,1}$, ..., $10_{n,2}$) hin mit der jeweiligen Einzelkapazität (C, C$_1$, ..., C$_4$) einer gegebenen Justiereinrichtung ($12_{1,1}$, ..., $12_{n,2}$) in Serie schaltbar ausgebildet ist.

**5.** Schaltungsanordnung nach Anspruch 4, **dadurch gekennzeichnet,**

- dass in der Schaltsteuereinrichtung (18, $18_{1,1}$, ..., $18_{n,2}$) für jede Einzelkapazität (C, C$_1$, ..., C$_4$) oder für mehrere oder alle Einzelkapazitäten einer, mehrerer oder aller Justiereinrichtungen ($12_{1,1}$, ..., $12_{n,2}$) ein Speicherelement, insbesondere ein 1-Bit-Speicherelement, vorgesehen ist und
- dass durch die Schaltsteuereinrichtung (18, $18_{1,1}$, ..., $18_{n,2}$) aufgrund des Inhalts des jeweiligen Speicherelements ein Steuersignal zum Setzen eines Schaltzustandes und/oder der Größe der jeweiligen Einzelkapazität (C, C$_1$, ...,

$C_4$) generierbar ist.

6. Schaltungsanordnung nach einem der vorangehenden Ansprüche,
**dadurch gekennzeichnet,**
dass eine Zugriffseinrichtung vorgesehen ist, durch
welche der Schaltzustand und/oder die Größe der
jeweiligen Einzelkapazität (C, $C_1$, ..., $C_4$), insbesondere extern, direkt oder indirekt im wesentlichen frei
einstellbar ist.

7. Schaltungsanordnung nach einem der vorangehenden Ansprüche,
**dadurch gekennzeichnet,**
dass die Werte der Ei-nzelkapazitäten ($C_1$, ..., $C_4$)
der Justiereinrichtungen ($12_{1,1}$, ..., $12_{n,2}$) jeweils
der Beziehung

$$C_j = C_0 \cdot 2^{j-1}$$

genügen, wobei j von 1 bis zur jeweiligen Anzahl
der Einzelkapazitäten, insbesondere bis 4, läuft und
wobei $C_0$ eine kleinste Grundkapazität, insbesondere etwa 10 fF, bedeutet.

8. Schaltungsanordnung nach einem der vorangehenden Ansprüche,
**dadurch gekennzeichnet**,
dass die Einzelkapazitäten (C, $C_1$, ..., $C_4$) der Justiereinrichtungen ($12_{1,1}$, ..., $12_{n,2}$) jeweils als
Sperrschicht- oder Diffusionschichtkapazität einer
Diode (45), eine n-Kanal-Feldeffekttransistors (44),
eines allgemeinen np-Übergangs (41, 42, 43) oder
dergleichen oder als Kapazität eines Metallschichtkondensators oder dergleichen ableitbar ist.

Fig. 1

Fig. 2

PAD

*10*

*25*

*21,...,24*

*4*

*31,...,34*

CTRL₁,...,CTRL₄

*18*

C₁,...,C₄

Fig.3

Fig. 4A

Fig. 4B

Fig. 4C